(19) Europäisches Patentamt
European Patent Office
Office européen des brevets

(11) **EP 2 375 454 B1**

(12) **EUROPEAN PATENT SPECIFICATION**

(45) Date of publication and mention
of the grant of the patent:
**24.07.2019 Bulletin 2019/30**

(21) Application number: **09833426.1**

(22) Date of filing: **15.12.2009**

(51) Int Cl.:
$H01L\ 31/04$ (2014.01)   $H01L\ 31/042$ (2014.01)
$H01L\ 31/18$ (2006.01)   $H01L\ 31/0224$ (2006.01)

(86) International application number:
**PCT/JP2009/070881**

(87) International publication number:
**WO 2010/071123 (24.06.2010 Gazette 2010/25)**

(54) **SOLAR BATTERY MODULE AND METHOD FOR MANUFACTURING SAME**

SOLARBATTERIEMODUL UND HERSTELLUNGSVERFAHREN DAFÜR

MODULE DE PILES SOLAIRES ET SON PROCÉDÉ DE FABRICATION

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **17.12.2008 JP 2008321527**

(43) Date of publication of application:
**12.10.2011 Bulletin 2011/41**

(73) Proprietor: **Panasonic Intellectual Property
Management Co., Ltd.
Osaka-shi, Osaka 540-6207 (JP)**

(72) Inventors:
• **SAITA, Atsushi
Osaka 570-8677 (JP)**

• **YOSHIMINE, Yukihiro
Osaka 570-8677 (JP)**

(74) Representative: **Mewburn Ellis LLP
City Tower
40 Basinghall Street
London EC2V 5DE (GB)**

(56) References cited:
**EP-A2- 1 928 027      WO-A1-2008/023795
WO-A1-2008/023795   JP-A- 2008 085 225
JP-A- 2008 205 045    JP-A- 2008 235 354
JP-A- 2008 235 354    JP-A- 2008 294 366
JP-A- 2008 294 366    US-A1- 2008 196 757**

## Description

### TECHNICAL FIELD

The present invention relates to a solar cell module including solar cells and a manufacturing method therefor.

[Background Art]

### BACKGROUND ART

A solar cell has been expected for new energy source, since it can convert solar light, which is supplied inexhaustibly and clean, directly into electricity.

Generally, a single solar cell can provide an output on the order of several watts, only. Therefore, when a solar cell is employed as a power source for a house, a building, and the like, a solar cell module is used in which a plurality of solar cells are connected to each other through a wiring member to increase the output. More specifically, a first wiring member is connected to a light receiving surface of a solar cell, whereas a second wiring member is connected to a back surface of the solar cell. The first wiring member of a solar cell is connected to a solar cell on one side thereof, while the second wiring member thereof is connected to a solar cell on the other side thereof.

A solar cell is known that has a plurality of light receiving surface side fine-line electrodes formed on the light receiving surface and a plurality of back surface side fine-line electrodes formed on the back surface (see Patent Literature 1). In such a solar cell, the light receiving surface side fine-line electrodes each partly bite into the first wiring member, and the back surface side fine-line electrodes each partly bite into the second wiring member. More specifically, the wiring members each have a conductive covering layer covering the core, and the fine-line electrodes bite into the covering layers of the wiring members.

Patent Literature 2 proposes a solar battery module with a plurality of solar battery cells which are connected to each other by connecting bus bar electrodes formed on the surfaces of the adjacent solar battery cells with wiring material.

Patent Literature 3 proposes a solar cell which includes a photoelectric conversion part, a thin line electrode on the light receiving side and a thin line electrode on the back side.

Patent Literature 4 proposes a solar cell module which includes two solar cells, each including a photoelectric conversion body.

Patent Literature 5 proposes a photoelectric converter which generates carriers by photoelectric conversion.

### PRIOR ART DOCUMENT

### PATENT DOCUMENT

Patent Literature 1: WO2008/023795
Patent Literature 2: EP2056355 A1
Patent Literature 3: JP 2008 294366 A
Patent Literature 4: EP 1928027 A2
Patent Literature 5: US 2008/196757 A

Patent Literature JP2008/235354-A discloses a solar cell module comprising finger electrodes wherein the finger electrodes on a back side of said module are wider than the finger electrodes on a front side of said module.

### SUMMARY OF THE INVENTION

In the solar cell, the light receiving surface side fine-line electrodes preferably have a small line width to increase the area of the light receiving surface. The back surface side fine-line electrodes preferably have a large line width or are provided in a large number to reduce electrical resistance. Thus, when the first and the second wiring members are pressed against the solar cell, the interval between the cores of the second wiring members and the back surface is larger than the interval between the cores of the first wiring members and the light receiving surface. As a result, there is a problem that the solar cell is more affected by the stretching force generated in the cores of the second wiring members due to change in temperature and thus is warped.

The present invention is made in view of the above problem, and an objective of the present invention is to provide a solar cell module and a manufacturing method of the solar cell module that are capable of preventing the solar cell from warping.

A solar cell module according to a first aspect of the present invention is set out in claim 1.

According to the solar cell module according to the aspect of the present invention, the solar cell receives substantially the same stresses from the first core of the first connecting member and the second core of the second connecting member. Thus, the stress applied to the solar cell from the first core of the first connecting member and the stress applied to the solar cell from the second core of the second connecting member can be canceled out with each other. Accordingly, the solar cell can be prevented from warping.

In the solar cell module, the plurality of light receiving surface side fine-line electrodes have a plurality of first connection portions connected to the first wiring member by biting into the first covering layer, the plurality of back surface side fine-line electrodes have a plurality of second connection portions connected to the second wiring member by biting into the second covering layer, and a total area of the plurality of first connection portions is smaller than a total area of the plurality of second connection portions in a plan view.

In the solar cell module, a height of the plurality of light receiving surface side fine-line electrodes is larger than a height of the plurality of back surface side fine-line electrodes, and a biting depth of the plurality of first connection portions in the first covering layer is larger than a biting depth of the plurality of second connection portions in the second covering layer.

A manufacturing method for a solar cell module according to a second aspect of the present invention is set out in claim 2.

In the following parts of the description the terms and expressions "embodiment" and "examples according to the present invention" are used. Irrespective of these terms and expressions, only those examples that fall under the scope of the independent claims form part of the invention.

According to the present invention, provided are a solar cell module and a manufacturing method of the solar cell module that are capable of preventing the solar cell from warping.

## BRIEF DESCRIPTION OF THE DRAWINGS

Fig. 1 is a side view of a solar cell module 100 according to an embodiment of the present invention.
Fig. 2 is a plan view of a solar cell 10 according to the embodiment of the present invention.
Fig. 3 is an enlarged cross-sectional view taken along the line A-A in Fig. 2(a).
Fig. 4 is an enlarged view of the solar cell 10 according to the embodiment of the present invention.
Fig. 5 is a plan view of a solar cell string 1 according to the embodiment of the present invention viewed from the light receiving surface side.
Fig. 6 is an enlarged cross-sectional view taken along the line B-B in Fig. 5.
Fig. 7 is a diagram for explaining an effect of the present invention.
Fig. 8 is a plan view of the solar cell 10 according to the embodiment of the present invention.

[Description of Embodiments]

Embodiments of the present invention will be explained with reference to drawings. In the description of the drawings, the same or similar constituent elements are designated by the same or similar reference numerals. It should be noted that the drawings are schematic and ratios of dimensions and the like are different from actual ones. Therefore, specific dimensions and the like should be determined in consideration of the following description. Moreover, the drawings also include portions having different dimensional relationships and ratios from each other, as a matter of course.

(Overall Configuration of Solar Cell Module)

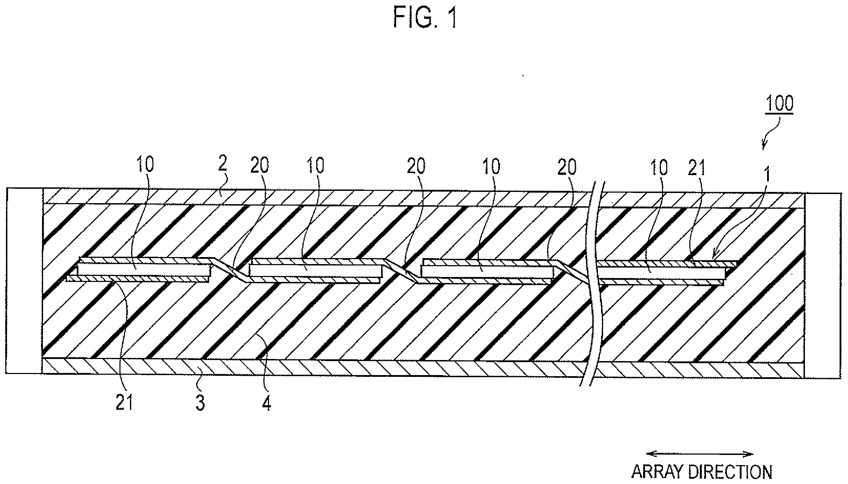

An overall configuration of a solar cell module 100 according to an embodiment of the present invention is described with reference to Fig. 1. Fig. 1 is a side view of the solar cell module 100 according to the embodiment.

The solar cell module 100 includes a solar cell string 1, a light receiving surface side protector 2, a back surface side protector 3, and a sealing member 4. The solar cell module 100 is formed by sealing the solar cell string 1 between the light receiving surface side protector 2 and the back surface side protector 3.

The solar cell string 1 includes a plurality of solar cells 10, connecting members 20, and output leads 21. The solar cell string 1 is formed by connecting the solar cells 10 arranged in an array direction to each other through the connecting members 20.

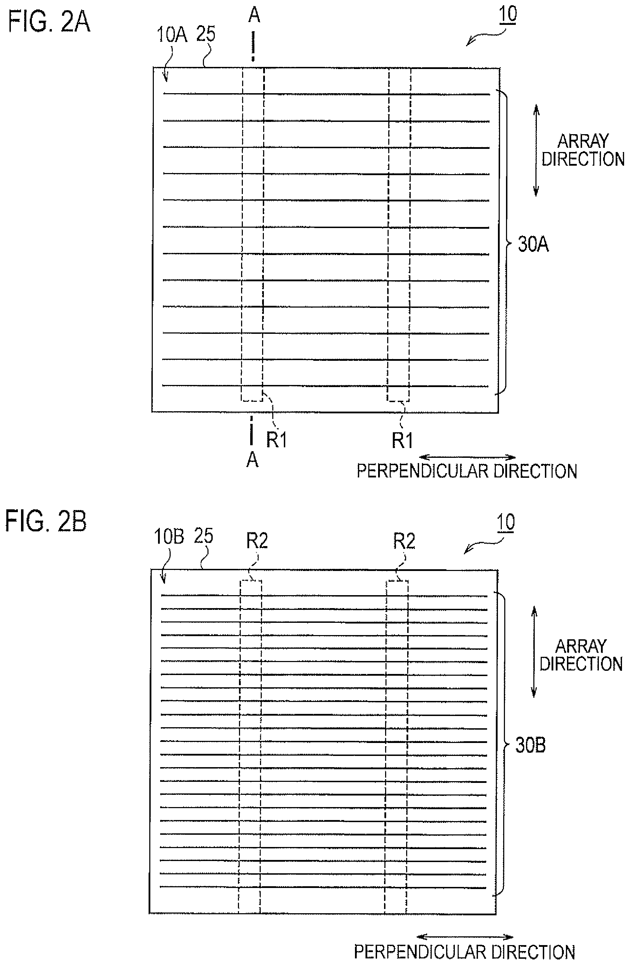

The solar cell 10 has a light receiving surface 10A on which solar light is incident and a back surface 10B formed on the side opposite to the light receiving surface 10A (see Fig. 2). The light receiving surface and the back surface are main surfaces of the solar cell 10. Collector electrodes are formed on the light receiving surface and the back surface of the solar cell 10. The configuration of the solar cell 10 is described later.

The connecting member 20 is a wiring member for electrically connecting the solar cells 10 to each other. More specifically, the connecting member 20 is adhered to the light receiving surface of one solar cell 10 and the back surface of the other solar cell 10 provided next to the one solar cell 10. Thus, the one solar cell 10 and the other solar cell 10 are electrically connected to each other. The configuration of the connecting member 20 is described later.

The output lead 21 is a wiring member for extracting current from the solar cell string 1. More specifically, the output lead 21 is adhered to the light receiving surface or the back surface of the solar cells 10 provided on both ends of the solar cell string 1. Although not illustrated, the output lead 21 may be extended to the outside of the solar cell module 100. The output lead 21 may be electrically connected to another solar cell string 1. The output lead 21 has a configuration the same as that of the connecting member 20.

The light receiving surface side protector 2 provided on the light receiving surface side of the sealing member 4 protects a front surface of the solar cell module 100. A translucent and water proof glass, a translucent plastic, or the like can be used as the light receiving surface side protector 2.

The back surface side protector 3 is provided on the back surface side of the sealing member 4. The back surface side protector 3 protects the back surface of the solar cell module 100. A resin film such as polyethylene terephthalate (PET), a laminate film formed by sandwiching an Al foil with resin films, and the like can be used as the back surface side protector 3.

The sealing member 4 seals the solar cell string 1 between the light receiving surface side protector 2 and the back surface side protector 3. A translucent resin such as EVA, EEA, PVB, silicon resin, urethane resin, acrylic resin, or epoxy resin can be used as the sealing member 4.

An Al frame (not shown) may be provided on the periphery of the solar cell module 100 configured as above.

(Configuration of Solar Cell)

Next, the configuration of the solar cell 10 is described with reference to Fig. 2. Fig. 2(a) is a plan view of the solar cell 10 viewed from the light receiving surface side. Fig. 2(b) is a plan view of the solar cell 10 viewed from the back surface side.

As shown in Fig. 2, the solar cell 10 includes a photoelectric conversion body 25, light receiving surface side fine-line electrodes 30A, and back surface side fine-line electrodes 30B. In the embodiment, first connecting members 20 are adhered to the light receiving surface 10A at regions R1, and second connecting members 20 are adhered to the back surface 10B at regions R2.

Upon receiving solar light, the photoelectric conversion body 25 generates photo-generated carriers. The photo-generated carriers are holes and electrons generated when solar light is absorbed by the photoelectric conversion body 25. The photoelectric conversion body 25 has an n-type region and a p-type region therein. A semiconductor junction is formed by an interface between the n-type region and the p-type region. The photoelectric conversion body 25 can be formed with a semiconductor substrate made of a semiconductor material such as a crystalline semiconductor material such as single-crystalline Si and polycrystalline Si or a compound semiconductor material such as GaAs and InP. The photoelectric conversion body 25 may have a so-called HIT structure in which a substantially intrinsic non-crystalline silicon layer is interposed between a single crystalline silicon substrate and a non-crystalline silicon layer to improve characteristics of the hetero junction interface.

The light receiving surface side fine-line electrodes 30A serve as a collector electrode that collects photo-generated carriers from the photoelectric conversion body 25. As shown in Fig. 2(a), the light receiving surface side fine-line electrodes 30A are formed on the light receiving surface 10A in a perpendicular direction substantially perpendicular to the array direction. M (M is a natural number) pieces of light receiving surface side fine-line electrodes 30A are formed on the entire light receiving surface of the photoelectric conversion body 25. The light receiving surface side fine-line electrodes 30A can be formed using a conductive paste.

The back surface side fine-line electrodes 30B serve as a collector electrode that collects photo-generated carriers from the photoelectric conversion body 25.

As shown in Fig. 2(b), the back surface side fine-line electrodes 30B are formed on the back surface 10B in a perpendicular direction substantially perpendicular to the array direction. N (N is a natural number larger than M) pieces of back surface side fine-line electrodes 30B are formed on the entire light receiving surface of the photoelectric conversion body 25. The back surface side fine-line electrodes 30B can be formed using the same material as that of light receiving surface side fine-line electrodes 30A.

(Configuration of Fine-Line Electrode)

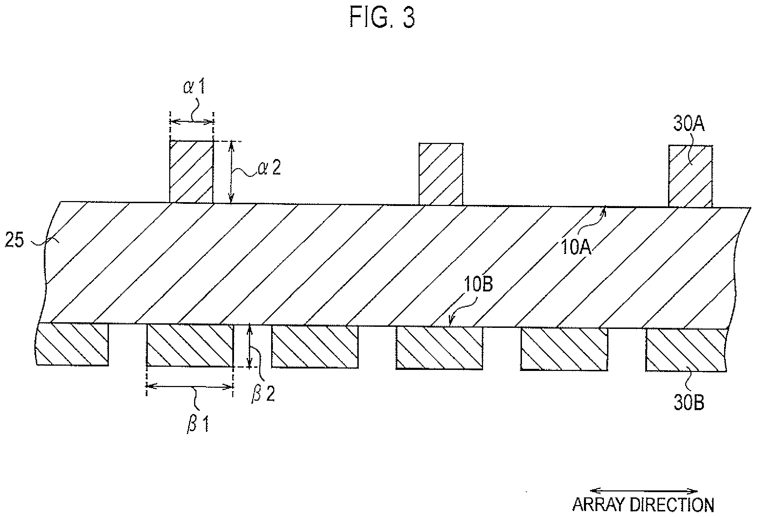

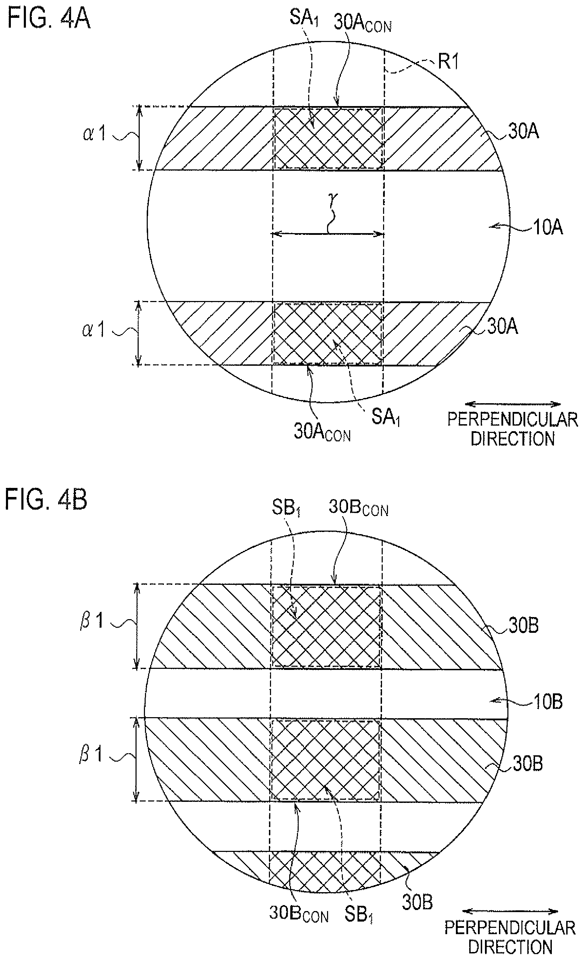

The configurations of the light receiving surface side fine-line electrodes 30A and the back surface side fine-line electrodes 30B are described with reference to Fig. 3 and Fig. 4. Fig. 3 is an enlarged cross-sectional view taken along the line A-A in Fig. 2(a). Fig. 4(a) is an enlarged view of the light receiving surface 10A. Fig. 4(b) is an enlarged view of the back surface 10B.

As shown in Fig. 3, the light receiving surface side fine-line electrodes 30A are formed to be thinner than the back surface side fine-line electrodes 30B in the array direction. More specifically, the line thickness $\alpha1$ of the light receiving surface side fine-line electrodes 30A is smaller than the line thickness $\beta1$ of the back surface side fine-line electrodes 30B. As shown in Fig. 3, the light receiving surface side fine-line electrodes 30A are formed to be taller than the back surface side fine-line electrodes 30B in the direction substantially perpendicular to the light receiving surface 10A. More specifically, the height $\alpha2$ of the light receiving surface side fine-line electrodes 30A is larger than the height $\beta2$ of the back surface side fine-line electrodes 30B. This is because a cross-sectional area of the light receiving surface side fine-line electrodes 30A is made larger in order to reduce the electrical resistance of the light receiving surface side fine-line electrodes 30A provided in a small number.

As shown in Fig. 4(a), the light receiving surface side fine-line electrodes 30A are formed in the region R1. The light receiving surface side fine-line electrodes 30A each has a first connection portion $30A_{CON}$ to be connected to the first connecting member 20 in a later manufacturing step. In a plan view of the light receiving surface 10A, the area $SA_1$ of a single first connection portion $30A_{CON}$ can be determined by the following formula (1) where y represents the width of the region R1.

$$SA_1 = y \times \alpha1 \ ... \ (1)$$

Accordingly, total area $SA_{ALL}$ of the M first connection portions $30A_{CON}$ of the M light receiving surface side fine-line electrodes 30A can be determined by the following formula (2).

$$SA_{ALL}=M\times\gamma\times\alpha1 \ ... \ (2)$$

As shown in Fig. 4(b), the back surface side fine-line electrodes 30B are formed in the region R2. The back surface side fine-line electrodes 30B each has a second connector $30B_{CON}$ to be connected to the second connecting member 20 in a later manufacturing step. In a plan view of the back surface 10B, the area $SB_1$ of a single second connector $30B_{CON}$ can be determined by the following formula (3) where $\gamma$ represents the width of the region R2.

$$SA_2=\gamma\times\beta1 \ ... \ (3)$$

Accordingly, total area $SB_{ALL}$ of the N second connectors $30B_{CON}$ of the N back surface side fine-line electrodes 30B can be determined by the following formula (4).

$$SB_{ALL}=N\times\gamma\times\beta1 \ ... \ (4)$$

When the total area $SA_{ALL}$ and the total area $SB_{ALL}$ are compared, total area $SA_{ALL}$<total area $SB_{ALL}$ holds true because N>M and $\beta1>\alpha1$.

(Configuration of Solar Cell String)

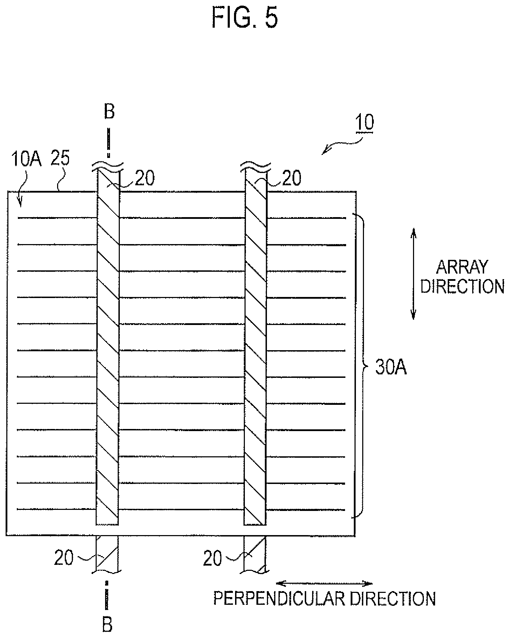

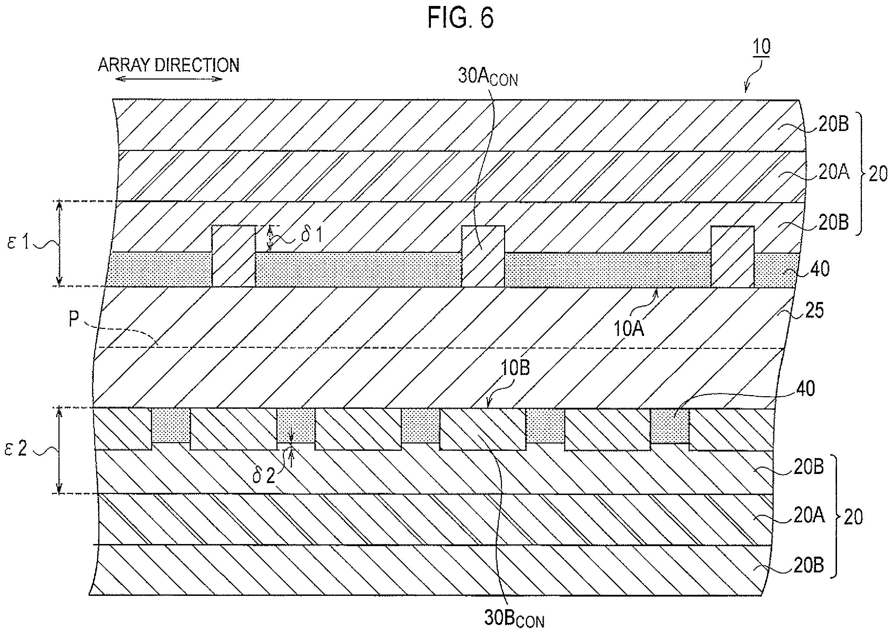

The configuration of the solar cell string 1 is described with reference to Fig. 5 and Fig. 6. Fig. 5 is a plan view of the solar cell string 1 viewed from the light receiving surface side. Fig. 6 is an enlarged cross-sectional view taken along the line B-B in Fig. 5. The line B-B in Fig. 5 coincides with a center line of the connecting member 20.

As shown in Fig. 5, the first connecting members 20 are connected on the light receiving surface 10A (regions R1). The second connecting members 20 are connected on the back surface 10B (regions R2).

As shown in Fig. 6, the connecting member 20 has a core 20A and a covering layer 20B. Preferably, the core 20A is formed of, for example, a material having low electric resistance such as copper, silver, gold, tin, nickel, aluminum, or an alloy of any of these formed into a thin plate or a twisted wire shape. The covering layer 20B is formed to cover the surface of the core 20A. The covering layer 20B is formed of a conductive material such as lead-free solder (e.g., $SnAg_{3.0}$, $Cu_{0.5}$).

The connecting members 20 are adhered to the light receiving surface 10A or the back surface 10B by a resin adhesive 40. The resin adhesive 40 is preferably cured at a temperature not higher than the melting point (about 200 °C) of the lead-free solder. As the resin adhesive 40, for example, a two-liquid reaction adhesive made by mixing a curing agent into an epoxy resin, acryl resin, or urethane resin, as well as an acryl resin and a highly flexible polyurethane thermoset resin adhesive can be used. The resin adhesive 40 includes a plurality of conducting particles. Nickel, gold coated nickel, and the like can be used as the conducting particles.

The first connection portions $30A_{CON}$ bite into the covering layers 20B of the first connecting members 20 to be mechanically and electrically connected to the first connecting members 20. Similarly, the second connection portions $30B_{CON}$ bite into the covering layers 20B of the second connecting members 20 to be mechanically and electrically connected to the second connecting members 20. It is to be noted that, biting depth $\delta1$ of the first connection portion $30A_{CON}$ is larger than biting depth $\delta2$ of the second connection portion $30B_{CON}$.

The interval $\varepsilon1$ from the core 20A of the first connecting member 20 to the light receiving surface 10A is substantially the same as the interval $\varepsilon2$ from the core 20A of the second connecting member 20 to the back surface 10B. Thus as shown in Fig. 6, a neutral plane P of the solar cell 10 appears at the center plane of the photoelectric conversion body 25. The neutral plane P is a virtual plane on which no pulling stress or compressing stress is applied even when the solar cell 10 deflects upward or downward. In the embodiment, the solar cell 10 receives substantially the same stresses from the cores 20A of the first connecting members 20 and the cores 20A of the second connecting members 20 because the neutral plane P of the solar cell 10 appears at the center plane of the photoelectric conversion body 25.

(Manufacturing Method for Solar Cell Module)

The manufacturing method for the solar cell module 100 according to the embodiment is described.

(Solar Cell Forming Step)

First, an epoxy-based thermoset-type silver paste is disposed on the light receiving surface and the back surface of the photoelectric conversion body 25 in a predetermined pattern by printing method such as screen printing and offset printing. The predetermined pattern is, for example, the pattern shown in Fig. 2. Then, the silver paste is dried in a predetermined condition so that the light receiving surface side fine-line electrodes 30A and the back surface side fine-line electrodes 30B are formed. Thus, the solar cell 10 is formed.

(Solar Cell String Forming Step)

Next, the solar cells 10 are electrically connected to each other through the connecting members 20. Subsequently, the output lead 21 is connected to each of the solar cells 10 provided on both ends. Thus, the solar cell string 1 is formed.

Specifically, the first connecting members 20 are provided on the regions R1 using the resin adhesive 40. The provided first connecting members 20 are pressed against the light receiving surface 10A of the solar cell 10 while being heated. This makes the first connection portions $30A_{CON}$ of the light receiving surface side fine-line electrodes 30A bitten into the covering layers 20B of the first connecting members 20. The second connecting members 20 are provided on the regions R2 using the resin adhesive 40. The provided second connecting members 20 are pressed against the back surface 10B of the solar cell 10 while being heated. This makes the second connection portions $30B_{CON}$ of the back surface side fine-line electrodes 30B bitten into the covering layers 20B of the second connecting members 20. The first connecting members 20 and the second connecting members 20 may be connected simultaneously or separately.

In this step, the interval $\varepsilon 1$ from the core 20A of the first connecting member 20 to the light receiving surface 10A is made substantially the same as the interval $\varepsilon 2$ from the core 20A of the second connecting member 20 to the back surface 10B by adjusting the pressing force applied to the first connecting members 20 and the second connecting members 20. More specifically, in the embodiment, the biting depth $\delta 1$ of the first connection portion $30A_{CON}$ is made larger than the biting depth $\delta 2$ of the second connection portion $30B_{CON}$ because the height $\alpha 2$ of the light receiving surface side fine-line electrodes 30A is larger than the height $\beta 2$ of the back surface side fine-line electrodes 30B. This adjustment is performed by changing the following two factors.

(1) Total Area of Connection Portions

The smaller total area $SA_{ALL}$ of the M first connection portions $30A_{CON}$ allows the first connection portions $30A_{CON}$ to bite deeper in the covering layer 20B. In other words, the smaller total area $SA_{ALL}$ of the M first connection portions $30A_{CON}$ allows the smaller interval $\varepsilon 1$. Similarly, the smaller total area $SB_{ALL}$ of the N second connection portions $30B_{CON}$ allows the second connection portions $30B_{CON}$ to bite deeper in the covering layer 20B. In other words, the smaller total area $SB_{ALL}$ of the N second connection portions $30B_{CON}$ allows the smaller interval $\varepsilon 2$.

The total area $SA_{ALL}$ and the total area $SB_{ALL}$ can also be changed by changing the shape of the top portions of the first connection portion $30A_{CON}$ and the second connection portion $30B_{CON}$ instead of changing the line widths $\alpha 1$ and $\beta 1$.

(2) Pressure Applied to Connection Portions of Connecting Member

The larger pressure from the first connecting member 20 to the first connection portions $30A_{CON}$ allows the first connection portions $30A_{CON}$ to bite deeper in the covering layer 20B. In other words, larger pressure from the first connecting member 20 to the first connection portions $30A_{CON}$ allows the smaller interval $\varepsilon 1$. The larger pressure from the second connecting member 20 to the second connection portions $30B_{CON}$ allows the second connection portions $30B_{CON}$ to bite deeper in the covering layer 20B. In other words, larger pressure from the second connecting member 20 to the second connection portions $30B_{CON}$ allows the smaller interval $\varepsilon 2$.

The pressure from the first connecting member 20 to the first connection portions $30A_{CON}$ can be changed by adjusting the pressing force applied to the first connecting member 20. The pressure from the second connecting member 20 to the second connection portions $30B_{CON}$ can be changed by adjusting the pressing force applied to the second connecting member 20.

When the first connecting member 20 and the second connecting member 20 are separately connected, the pressure force applied to the first connecting member 20 and the second connecting member 20 can be independently controlled. When the first connecting member 20 and the second connecting member 20 are simultaneously connected, the same pressing force is applied to the first connecting member 20 and the second connecting member 20.

(Modularization Step)

Next, a laminated body is formed by sequentially stacking an EVA sheet (the sealing member 4), the solar cell string 1, another EVA sheet (the sealing member 4), and a PET sheet (the back surface side protector 3) on a glass substrate (the light receiving surface side protector 2).

Subsequently, the laminated body is pressure bonded while being heated in vacuum atmosphere to be temporarily pressure bonded and then is heated at a predetermined condition so that the EVA is hardened. Thus, the solar cell module 100 is fabricated. A terminal box, an Al frame, and the like can be attached to the solar cell module 100. One end of the output lead 21 is stored in the terminal box.

(Advantageous Effects)

In the solar cell module 100 according to the embodiment, the interval $\varepsilon 1$ from the core 20A of the first connecting member 20 to the light receiving surface 10A is substantially the same as the interval $\varepsilon 2$ from the core 20A of the second connecting member 20 to the back surface 10B.

The solar cell 10 receives substantially the same stresses from the core 20A of the first connecting member 20 and the core 20A of the second connecting member 20. Thus, the stress applied to the solar cell 10 from the core 20A of the first connecting member 20 and the stress applied to the solar cell 10 from the core 20A of the second connecting member 20 can be canceled out with each other. Accordingly, the solar cell 10 can be prevented from warping.

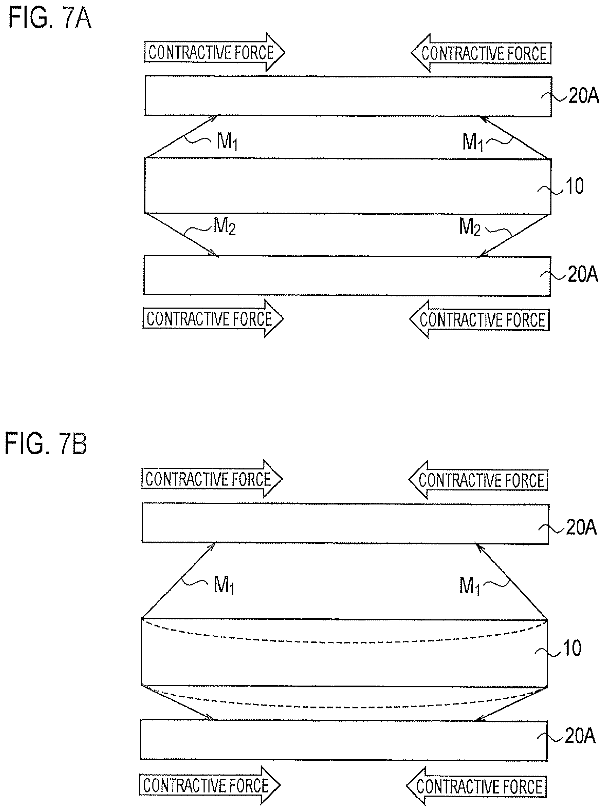

More specifically, as shown in Fig. 7(a), the same intervals between the solar cell 10 and the two cores 20A balance moments $M_1$ and $M_2$ produced at the ends of the solar cell 10, whereby the solar cell 10 does not warp. On the other hand, as shown in Fig. 7(b), the different intervals between the solar cell 10 and the two cores 20A do not balance moments $M_1$ and $M_2$ produced at the ends of the solar cell 10, whereby the solar cell 10 warps.

In the solar cell 10 according to the embodiment, the total area $SA_{ALL}$ of the M first connection portions $30A_{CON}$ is smaller than the total area $SB_{ALL}$ of the N second connection portions $30B_{CON}$. Moreover, the light receiving surface side fine-line electrodes 30A are taller than the back surface side fine-line electrodes 30B. In such a solar cell 10, since the intervals ε1 and ε2 are likely to be different, the solar cell 10 is especially likely to warp.

Thus, the manufacturing method for the solar cell module 100 according to the embodiment adjusts the total area $SA_{ALL}$, the total area $SB_{ALL}$, and the pressing force applied to the connecting members 20 to equalize the intervals ε1 and ε2. Accordingly, the solar cell 10 can be properly prevented from warping even with a structure in which the solar cell 10 is likely to warp.

(Other Embodiments)

The present invention has been described by using the embodiment described above. However, it should not be understood that the description and drawings which constitute part of this disclosure limit the invention. From this disclosure, various alternative embodiments, examples, and operation techniques will be easily found by those skilled in the art.

For example, in the embodiment, description is given of two connecting members 20 connected to the solar cell 10. However, the prevent invention is also effective in a case where a single first connecting member 20 and a single lead output 21 are connected to the solar cell 10.

In the embodiment, the line width α1 of the light receiving surface side fine-line electrode 30A is smaller than the line width β1 of the back surface side fine-line electrode 30B. However, the present invention is not limited thereto. The line widths α1 and β1 can be the same, or the line width α1 can be larger than the line width β1.

In the embodiment, the height α2 of the light receiving surface side fine-line electrode 30A is larger than the height β2 of the back surface side fine-line electrode 30B. However, the present invention is not limited thereto. The heights α2 and β2 can be the same, or the height α2 can be smaller than the height β2.

In the embodiment, the number M of the light receiving surface side fine-line electrode 30A is smaller than the number N of the back surface side fine-line electrode 30B. However, the present invention is not limited thereto. The number M and the number N can be the same, or the number M can be larger than the number N.

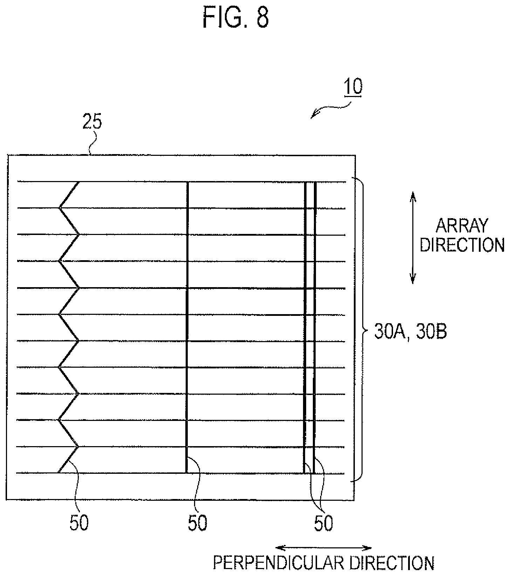

In the embodiment, the solar cell 10 has the light receiving surface side fine-line electrodes 30A and the back surface side fine-line electrodes 30B as the collector electrodes. However, the present invention is not limited thereto. The solar cell 10 may further include a connecting wire 50. The connecting wire 50 electrically connects the light receiving surface side fine-line electrodes 30A to each other or the back surface side fine-line electrodes 30B to each other. Specifically, as shown in Fig. 8, the shape and the number of connecting member 50 are not limited.

In the embodiment, the light receiving surface side fine-line electrodes 30A and the back surface side fine-line electrodes 30B are formed in the perpendicular direction. However, the present invention is not limited thereto. The shape and the scale of the light receiving surface side fine-line electrodes 30A and the back surface side fine-line electrodes 30B are not particularly limited in the present invention.

In the embodiment, the total area $SA_{ALL}$, the total area $SB_{ALL}$, and the pressing force applied to the connecting members 20 are adjusted to equalize the intervals ε1 and ε2. However, it is only sufficient to adjust either one of these. More specifically, if the total area $SA_{ALL}$ and the total area $SB_{ALL}$ are fixed values, only the pressing force applied to the connecting members 20 should be adjusted. If the pressing force applied to the connecting members 20 is a fixed value, at least one of the total area $SA_{ALL}$ and the total area $SB_{ALL}$ should be adjusted.

**Examples**

Hereinafter, the examples of the solar cell used for the solar cell module according to the present invention will be described concretely.

First, a 125 mm × 125 mm light receiving surface of a photoelectric conversion body was provided with light receiving surface side fine-line electrodes (line width 70 μm, height 50 μm, pitch 2.2 mm) by screen printing using epoxy-based thermoset-type silver paste. The total area of first connection portions to which connecting members were connected was 11.55 mm².

Next, the back surface of a photoelectric conversion body was provided with back surface side fine-line electrodes (line width 105 μm, height 20 μm, pitch 0.55 mm) by screen printing using the epoxy-based thermoset-type silver paste. The total area of second connection portions to which connecting members were connected was 69.62 mm² (six times as large as the total area of the first connection portions).

Next, three connecting members (line width 1 mm) were adhered on each of the light receiving surface and the back surface of the solar cell using a tape-shaped resin adhesive. More specifically, the connecting members were pressurized for 20 seconds at 2 MPa while being heated at 200 °C. The connecting member was made by covering the surface of a copper foil having the thickness of 200 μ by a solder layer having the thickness of 40 μm.

Here, the pressure applied to the first connection portions was 85.8 MPa, and the pressure applied to the second connection portions was 14.2 MPa (about one-sixth of 85.8 MPa). The first connection portions bites into the connecting member for 25 μm. The second connection portions bites into the connecting member for 1 μm. Accordingly, the interval between the light receiving surface and the copper foil and the interval between the back surface and the other copper foil were both 20 μm.

No warpage was observed in the solar cell to which the connecting members were connected as described above. This is because the stresses applied to the solar cell from the two copper foils were able to be canceled out with each other by equalizing the interval between the light receiving surface and the copper foil and the interval between the back surface and the copper foil.

## INDUSTRIAL APPLICABILITY

As described above, the solar cell module and the manufacturing method therefor according to the present invention can prevent the solar cell from warping, and thus are advantageous to be used in a field of solar cell manufacturing.

## REFERENCE SIGNS LIST

| | |
|---|---|
| 1 | solar cell string |
| 2 | light receiving surface side protector |
| 3 | back surface side protector |
| 4 | sealing member |
| 10 | solar cell |
| 10A | light receiving surface |
| 10B | back surface |
| 20 | connecting member |
| 20A | core |
| 20B | covering layer |
| 21 | output lead |
| 25 | photoelectric conversion body |
| 30A | light receiving surface side fine-line electrode |
| $30A_{CON}$ | first connection portion |
| 30B | back surface side fine-line electrode |
| $30B_{CON}$ | second connection portion |
| 40 | resin adhesive |
| 50 | connecting wire |
| 100 | solar cell module |

## Claims

**1.** A solar cell module (100) comprising:

a solar cell (10) including

a plurality of light receiving surface side fine-line electrodes (30A) formed on a light receiving surface (10A), and
a plurality of back surface side fine-line electrodes (30B) formed on a back surface (10B) opposite to the light receiving surface (10A);

a first wiring member (20) connected onto the light receiving surface (10A) and connected to the plurality of light receiving surface side fine-line electrodes (30A); and
a second wiring member (20) connected onto the back surface (10B) and connected to the plurality of back surface side fine-line electrodes (30B), wherein
the first wiring member (20) includes

a conductive first core (20A), and
a conductive first covering layer (20B) formed on a surface of the first core (20A), and

the second wiring member (20) includes

a conductive second core (20A), and
a conductive second covering layer (20B) formed on a surface of the second core (20A),

wherein
a line width ($\alpha$1) of the plurality of light receiving surface side fine-line electrodes (30A) is smaller than a line width ($\beta$1) of the plurality of back surface side fine-line electrodes (30B),
the plurality of light receiving surface side fine-line electrodes (30A) have a plurality of first connection portions ($30A_{CON}$) connected to the first wiring member (20) by biting into the first covering layer (20B),
the plurality of back surface side fine-line electrodes (30B) have a plurality of second connection portions ($30B_{CON}$) connected to the second wiring member (20) by biting into the second covering layer (20B),
a total area of the plurality of first connection portions ($30A_{CON}$) is smaller than a total area of the plurality of second connection portions ($30B_{CON}$) in a plan view, and
an interval ($\epsilon$1) between the light receiving surface (10A) and the surface of the first core (20A) is substantially the same as an interval ($\epsilon$2) between the back surface (10B) and the surface of the second core (20A)
**characterized in that**
a height ($\alpha$2) of the plurality of light receiving surface side fine-line electrodes (30A) is larger than a height ($\beta$2) of the plurality of back surface side fine-line electrodes (30B), and the number (M) of the plurality of light receiving side fine-line electrodes (30A) is smaller than the number (N) of the plurality of back surface side fine-line electrodes (30B), and further **characterized in that** a biting depth ($\delta$1) of the plurality of first connection portions (30A) in the first covering layer (20B) is larger than a biting depth ($\delta$2) of the plurality of second connection portions (30B) in the second covering layer (20B).

2. A manufacturing method for a solar cell module (100) including a solar cell (10) having a photoelectric conversion body (25), the method comprising:

a step A of forming the solar cell (10) by forming a plurality of light receiving surface side fine-line electrodes (30A) on a light receiving surface (10A) of the photoelectric conversion body (25), and forming a plurality of back surface side fine-line electrodes (30B) on a back surface (10B) of the photoelectric conversion body (25) opposite to the light receiving surface (10A);

a step B of pressing a first wiring member (20) having a first core (20A) and a first covering layer (20B) formed on a surface of the first core (20A), against the light receiving surface (10A) to connect the first wiring member (20) onto the light receiving surface (10A) and to the plurality of light receiving surface side fine-line electrodes (30A); and

a step C of pressing a second wiring member (20) having a second core (20A) and a second covering layer (20B) formed on a surface of the second core (20A), against the back surface (10B) to connect the second wiring member (20) onto the back surface (10B) and to the plurality of back surface side fine-line electrodes (30B),

**characterized in that**:

a line width ($\alpha$1) of the plurality of light receiving surface side fine-line electrodes (30A) is smaller than a line width ($\beta$1) of the plurality of back surface side fine-line electrodes (30B),

the plurality of light receiving surface side fine-line electrodes (30A) have a plurality of first connection portions (30A$_{CON}$) connected to the first wiring member (20) by biting into the first covering layer (20B),

the plurality of back surface side fine-line electrodes (30B) have a plurality of second connection portions (30B$_{CON}$) connected to the second wiring member (20) by biting into the second covering layer (20B),

a total area of the plurality of first connection portions (30A$_{CON}$) is smaller than a total area of the plurality of second connection portions (30B$_{CON}$) in a plan view, and

in the step B and the step C, an interval ($\epsilon$1) between the light receiving surface (10A) and the surface of the first core (20A) and an interval ($\epsilon$1) between the back surface (10B) and the surface of the second core (20B) are controlled to be substantially the same **characterized in that**

a height ($\alpha$2) of the plurality of light receiving surface side fine-line electrodes (30A) is larger than a height ($\beta$2) of the plurality of back surface side fine-line electrodes (30B), and the number (M) of the plurality of light receiving side fine-line electrodes (30A) is smaller than the number (N) of the plurality of back surface side fine-line electrodes (30B), and further **characterized in that** a biting depth ($\delta$1) of the plurality of first connection portions (30A) in the first covering layer (20B) is larger than a biting depth ($\delta$2) of the plurality of second connection portions (30B) in the second covering layer (20B).

**Patentansprüche**

1. Solarzellenmodul (100), das Folgendes umfasst:

eine Solarzelle (10), umfassend

eine Vielzahl von lichtempfangenden Oberflächenseiten-Feinlinienelektroden (30A), die auf einer lichtempfangenden Oberfläche (10A) ausgebildet ist, und eine Vielzahl von lichtempfangenden Rückseitenoberflächenseiten-Feinlinienelektroden (30B), die auf einer der lichtempfangenden Oberfläche (10A) gegenüberliegenden Rückseitenoberfläche (10B) ausgebildet ist;

ein erstes Verdrahtungselement (20), das mit der lichtempfangenden Oberfläche (10A) verbunden ist und mit der Vielzahl von lichtempfangenden Oberflächenseiten-Feinlinienelektroden (30A) verbunden ist; und ein zweites Verdrahtungselement (20), das mit der Rückseitenoberfläche (10B) verbunden ist und mit der Vielzahl von Rückseitenoberflächenseiten-Feinlinienelektroden (30B) verbunden ist,

wobei

das erste Verdrahtungselement (20)

einen leitfähigen ersten Kern (20A) und

eine leitfähige erste Abdeckschicht (20B) umfasst, die auf einer Oberfläche des ersten Kerns (20A) ausgebildet ist, und

das zweite Verdrahtungselement (20)

einen leitfähigen zweiten Kern (20A) und eine leitfähige zweite Abdeckschicht (20B) umfasst, die auf einer Oberfläche des zweiten Kerns (20A) ausgebildet ist,

wobei

eine Linienbreite ($\alpha$1) der Vielzahl von lichtempfangenden Oberflächenseiten-Feinlinienelektroden (30A) kleiner ist als eine Linienbreite ($\beta$1) der Vielzahl von Rückseitenoberflächenseiten-Feinlinienelektroden (30B),
die Vielzahl von lichtempfangenden Oberflächenseiten-Feinlinienelektroden (30A) eine Vielzahl von ersten Verbindungsabschnitten (30A$_{CON}$) aufweist, die mit dem ersten Verdrahtungselement (20) durch Eindringen in die erste Abdeckschicht (20B) verbunden ist,
die Vielzahl von Rückseiten-Feinlinienelektroden (30B) eine Vielzahl von zweiten Verbindungsabschnitten (30B$_{CON}$) aufweist, die durch Eindringen in die zweite Abdeckungsschicht (20B) mit dem zweiten Verdrahtungselement (20) verbunden ist,
eine Gesamtfläche der Vielzahl von ersten Verbindungsabschnitten (30A$_{CON}$) kleiner ist als eine Gesamtfläche der Vielzahl von zweiten Verbindungsabschnitten (30B$_{CON}$) in einer Draufsicht, und
ein Abstand ($\epsilon$1) zwischen der lichtempfangenden Oberfläche (10A) und der Oberfläche des ersten Kerns (20A) im Wesentlichen derselbe ist wie ein Abstand ($\epsilon$2) zwischen der Rückseitenoberfläche (10B) und der Oberfläche des zweiten Kerns (20A),
**dadurch gekennzeichnet, dass**
eine Höhe ($\alpha$2) der Vielzahl von lichtempfangenden Oberflächenseiten-Feinlinienelektroden (30A) größer ist als eine Höhe ($\beta$2) der Vielzahl von Rückseitenseiten-Feinlinienelektroden (30B), und
die Anzahl (M) der Vielzahl von lichtempfangenden Seiten-Feinlinienelektroden (30A) geringer ist als die Anzahl (N) der Vielzahl von Rückseitenoberflächenseiten-Feinlinienelektroden (30B), und ferner **dadurch gekennzeichnet, dass**
eine Eindringtiefe ($\delta$1) der Vielzahl von ersten Verbindungsabschnitten (30A) in der ersten Abdeckungsschicht (20B) größer ist als eine Eindringtiefe ($\delta$2) der Vielzahl von zweiten Verbindungsabschnitten (30B) in der zweiten Abdeckungsschicht (20B).

2. Herstellungsverfahren für ein Solarzellenmodul (100), einschließlich einer Solarzelle (10) mit einem photoelektrischen Umwandlungskörper (25), wobei das Verfahren Folgendes umfasst:

einen Schritt A des Ausbildens der Solarzelle (10) durch Ausbilden einer Vielzahl von lichtempfangenden Oberflächenseiten-Feinlinienelektroden (30A) auf einer lichtempfangenden Oberfläche (10A) des photoelektrischen Umwandlungskörpers (25), und Ausbilden einer Vielzahl von Rückseitenoberflächenseiten-Feinlinienelektroden (30B) auf einer Rückseitenoberfläche (10B) des photoelektrischen Umwandlungskörpers (25), die der lichtempfangenden Oberfläche (10A) gegenüberliegt;
einen Schritt B des Pressens eines ersten Verdrahtungselements (20) mit einem ersten Kern (20A) und einer ersten Abdeckschicht (20B), die auf einer Oberfläche des ersten Kerns (20A) ausgebildet wurde, gegen die lichtempfangende Oberfläche (10A), um das erste Verdrahtungselement (20) mit der lichtempfangenden Oberfläche (10A) und der Vielzahl von lichtempfangenden Oberflächenseiten-Feinlinienelektroden (30A) zu verbinden; und
einen Schritt C des Pressens eines zweiten Verdrahtungselements (20) mit einem zweiten Kern (20A) und einer zweiten Abdeckschicht (20B), die auf einer Oberfläche des zweiten Kerns (20A) ausgebildet wurde, gegen die Rückseitenoberfläche (10B), um das zweite Verdrahtungselement (20) mit der Rückseitenoberfläche (10B) und der Vielzahl von Rückseiten-Feinlinienelektroden (30B) zu verbinden,
**dadurch gekennzeichnet, dass**:

eine Linienbreite ($\alpha$1) der Vielzahl von lichtempfangenden Oberflächenseiten-Feinlinienelektroden (30A) geringer ist als eine Linienbreite ($\beta$1) der Vielzahl von Rückseitenseiten-Feinlinienelektroden (30B),
die Vielzahl von lichtempfangenden Oberflächenseiten-Feinlinienelektroden (30A) eine Vielzahl von ersten Verbindungsabschnitten (30A$_{CON}$) aufweist, die durch Eindringen in die erste Abdeckungsschicht (20B) mit dem ersten Verdrahtungselement (20) verbunden ist,
die Vielzahl von Rückseitenoberflächenseiten-Feinlinienelektroden (30B) eine Vielzahl von zweiten Verbindungsabschnitten (30B$_{CON}$) aufweist, die durch Eindringen in die zweite Abdeckungsschicht (20B) mit dem zweiten Verdrahtungselement (20) verbunden ist,

eine Gesamtfläche der Vielzahl von ersten Verbindungsabschnitten (30A$_{CON}$) kleiner ist als eine Gesamtfläche der Vielzahl von zweiten Verbindungsabschnitten (30B$_{CON}$) in einer Draufsicht, und

in Schritt B und Schritt C ein Abstand ($\varepsilon$1) zwischen der lichtempfangenden Oberfläche (10A) und der Oberfläche des ersten Kerns (20A) und ein Abstand ($\varepsilon$1) zwischen der Rückseitenoberfläche (10B) und der Oberfläche des zweiten Kerns (20B) gesteuert werden, um im Wesentlichen dieselben zu sein,

**dadurch gekennzeichnet, dass**:
eine Höhe ($\alpha$2) der Vielzahl von lichtempfangenden Oberflächenseiten-Feinlinienelektroden (30A) größer ist als eine Höhe ($\beta$2) der Vielzahl von Rückseitenoberflächenseiten-Feinlinienelektroden (30B), und die Anzahl (M) der Vielzahl von Feinlinienelektroden der lichtempfangenden Seite (30A) geringer ist als die Anzahl (N) der Vielzahl von Rückseitenoberflächenseiten-Feinlinienelektroden (30B) und ferner **dadurch gekennzeichnet, dass**:
eine Eindringtiefe ($\delta$1) der Vielzahl von ersten Verbindungsabschnitten (30A) in der ersten Abdeckungsschicht (20B) größer ist als eine Eindringtiefe ($\delta$2) der Vielzahl von zweiten Verbindungsabschnitten (30B) in der zweiten Abdeckungsschicht (20B).

**Revendications**

1. Module de pile solaire (100) comprenant :

une pile solaire (10) comprenant

une pluralité d'électrodes à lignes fines côté surface de réception de lumière (30A) formées sur une surface de réception de lumière (10A), et
une pluralité d'électrodes à lignes fines côté surface arrière (30B) formées sur une surface arrière (10B) opposée à la surface de réception de lumière (10A) ;

un premier élément de câblage (20) connecté à la surface de réception de lumière (10A) et connecté à la pluralité d'électrodes à lignes fines côté surface de réception de lumière (30A) ; et
un second élément de câblage (20) connecté à la surface arrière (10B) et connecté à la pluralité d'électrodes à lignes fines côté surface arrière (30B), dans lequel
le premier élément de câblage (20) comprend

un premier noyau conducteur (20A), et
une première couche de recouvrement conductrice (20B) formée sur une surface du premier noyau (20A), et

le second élément de câblage (20) comprend

un second noyau conducteur (20A), et
une seconde couche de revêtement conductrice (20B) formée sur une surface du second noyau (20A),

dans lequel
une largeur de ligne ($\alpha$1) de la pluralité d'électrodes à lignes fines côté surface de réception de lumière (30A) est inférieure à une largeur de ligne ($\beta$1) de la pluralité d'électrodes à lignes fines côté surface arrière (30B),
la pluralité d'électrodes à lignes fines côté surface de réception de lumière (30A) a une pluralité de premières parties de connexion (30A$_{CON}$) connectées au premier élément de câblage (20) en mordant dans la première couche de recouvrement (20B),
la pluralité d'électrodes à lignes fines côté surface arrière (30B) a une pluralité de secondes parties de connexion (30B$_{CON}$) connectées au second élément de câblage (20) en mordant dans la seconde couche de recouvrement (20B),
une surface totale de la pluralité de premières parties de connexion (30A$_{CON}$) est inférieure à une surface totale de la pluralité de secondes parties de connexion (30B$_{CON}$) dans une vue de dessus, et
un intervalle ($\varepsilon$1) entre la surface de réception de lumière (10A) et la surface du premier noyau (20A) est sensiblement identique à un intervalle ($\varepsilon$2) entre la surface arrière (10B) et la surface du second noyau (20A)
**caractérisé en ce que**
une hauteur ($\alpha$2) de la pluralité d'électrodes à lignes fines côté surface de réception de lumière (30A) est supérieure à une hauteur ($\beta$2) de la pluralité d'électrodes à lignes fines côté surface arrière (30B), et le nombre (M) de la pluralité d'électrodes à lignes fines côté surface de réception de lumière (30A) est inférieur au nombre (N) de la pluralité d'électrodes à lignes fines côté surface arrière (30B), et **caractérisé en outre en ce que**
une profondeur de morsure ($\delta$1) de la pluralité de premières parties de connexion (30A) dans la première couche de recouvrement (20B) est supérieure à une profondeur de morsure ($\delta$2) de la pluralité de secondes parties de connexion (30B) dans la seconde couche de recouvrement (20B).

2. Procédé de fabrication d'un module de pile solaire (100) comprenant une pile solaire (10) ayant un corps de conversion photoélectrique (25), le procédé comprenant :

une étape A consistant à former la pile solaire (10) en formant une pluralité d'électrodes à lignes fines côté surface de réception de lumière (30A) sur une surface de réception de lumière (10A) du corps de conversion photoélectrique (25), et à former une pluralité d'électrodes à lignes fines côté surface arrière (30B) sur une surface arrière (10B) du corps de conversion photoélectrique (25) opposée à la surface de réception de lumière (10A) ;

une étape B consistant à presser un premier élément de câblage (20) comprenant un premier noyau (20A) et une première couche de recouvrement (20B) formée sur une surface du premier noyau (20A) contre la surface de réception de lumière (10A) pour connecter le premier élément de câblage (20) sur la surface de réception de lumière (10A) et à la pluralité d'électrodes à lignes fines côté surface de réception de lumière (30A) ; et

une étape C consistant à presser un second élément de câblage (20) comportant un second noyau (20A) et une seconde couche de recouvrement (20B) formée sur une surface du second noyau (20A) contre la surface arrière (10B) pour connecter le second un élément de câblage (20) sur la surface arrière (10B) et à la pluralité d'électrodes à lignes fines côté surface arrière (30B),

**caractérisé en ce que** :

une largeur de ligne ($\alpha$1) de la pluralité d'électrodes à lignes fines côté surface de réception de lumière (30A) est inférieure à une largeur de ligne ($\beta$1) de la pluralité d'électrodes à lignes fines côté surface arrière (30B),

la pluralité d'électrodes à lignes fines côté surface de réception de lumière (30A) a une pluralité de premières parties de connexion (30A$_{CON}$) connectées au premier élément de câblage (20) en mordant dans la première couche de recouvrement (20B),

la pluralité d'électrodes à lignes fines côté surface arrière (30B) a une pluralité de secondes parties de connexion (30B$_{CON}$) connectées au second élément de câblage (20) en mordant dans la seconde couche de recouvrement (20B),

une surface totale de la pluralité de premières parties de connexion (30A$_{CON}$) est inférieure à une surface totale de la pluralité de secondes parties de connexion (30B$_{CON}$) dans une vue de dessus, et

dans l'étape B et l'étape C, un intervalle ($\epsilon$1) entre la surface de réception de lumière (10A) et la surface du premier noyau (20A) et un intervalle ($\epsilon$1) entre la surface arrière (10B) et la surface du second noyau (20B) sont commandés pour être sensiblement identiques

**caractérisé en ce que**

une hauteur ($\alpha$2) de la pluralité d'électrodes à lignes fines côté surface de réception de lumière (30A) est supérieure à une hauteur ($\beta$2) de la pluralité d'électrodes à lignes fines côté surface arrière (30B), et le nombre (M) de la pluralité d'électrodes à lignes fines côté réception de lumière (30A) est inférieure au nombre (N) de la pluralité d'électrodes à lignes fines côté surface arrière (30B) et est **caractérisé en outre en ce que**

une profondeur de morsure ($\delta$1) de la pluralité de premières parties de connexion (30A) dans la première couche de recouvrement (20B) est supérieure à une profondeur de morsure ($\delta$2) de la pluralité de secondes parties de connexion (30B) dans la seconde couche de recouvrement (20B).

EP 2 375 454 B1

# FIG. 1

ARRAY DIRECTION

FIG. 2A

10A  25
A

10

ARRAY
DIRECTION

30A

R1                    R1

A

PERPENDICULAR DIRECTION

FIG. 2B

10B  25    R2          R2        10

ARRAY
DIRECTION

30B

PERPENDICULAR DIRECTION

FIG. 3

ARRAY DIRECTION

FIG. 4A

FIG. 4B

# FIG. 5

# FIG. 6

EP 2 375 454 B1

FIG. 7A

CONTRACTIVE FORCE → ← CONTRACTIVE FORCE

20A

$M_1$ $M_1$

10

$M_2$ $M_2$

20A

CONTRACTIVE FORCE → ← CONTRACTIVE FORCE

FIG. 7B

CONTRACTIVE FORCE → ← CONTRACTIVE FORCE

20A

$M_1$ $M_1$

10

20A

CONTRACTIVE FORCE → ← CONTRACTIVE FORCE

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008023795 A
- EP 2056355 A1
- JP 2008294366 A
- EP 1928027 A2
- US 2008196757 A
- JP 2008235354 A